**Europäisches Patentamt**

**European Patent Office**

**Office européen des brevets**

(11) Veröffentlichungsnummer: **0 317 019**
**A2**

# EUROPÄISCHE PATENTANMELDUNG

(21) Anmeldenummer: **88202550.5**

(22) Anmeldetag: **15.11.88**

(51) Int. Cl.⁴ **C23C 16/50 , C23C 16/06 , C23C 16/08 , C23C 16/18**

(30) Priorität: **17.11.87 DE 3738993**

(43) Veröffentlichungstag der Anmeldung:
**24.05.89 Patentblatt 89/21**

(84) Benannte Vertragsstaaten:
**DE FR GB**

(71) Anmelder: **Philips Patentverwaltung GmbH**
**Wendenstrasse 35 Postfach 10 51 49**
**D-2000 Hamburg 1(DE)**

(84) **DE**

Anmelder: **N.V. Philips' Gloeilampenfabrieken**
**Groenewoudseweg 1**
**NL-5621 BA Eindhoven(NL)**

(84) **FR GB**

(72) Erfinder: **Gärtner, Georg, Dr.**
**Martelenberger Weg 16b**
**D-5100 Aachen(DE)**
Erfinder: **Janiel, Peter**
**Otto-Dix-Strasse 1**
**D-5102 Würselen(DE)**

(74) Vertreter: **Piegler, Harald, Dipl.-Chem. et al**
**Philips Patentverwaltung GmbH**
**Wendenstrasse 35 Postfach 10 51 49**
**D-2000 Hamburg 1(DE)**

(54) **Verfahren zur glimmentladungsaktivierten reaktiven Abscheidung von Metall aus einer Gasphase.**

(57) Zur reaktiven Abscheidung von rohrförmigen Körpern aus Metall, z.B. selbsttragenden Glühkathoden sowie Schichten und Formkörpern für Hochtemperaturanwendungen, aus einer ein Metallhalogenid enthaltenden strömenden Gasphase (18) auf einem rohrförmigen Substrat wird zwischen einer Innenelektrode (7) und einer Außenelektrode (3), von denen eine rohrförmig ausgebildet ist und als Substrat dient, eine Glimmentladung (13) erzeugt. Eine hohe Ausbeute der Metallabscheidung wird dadurch erhalten, daß die reaktive Abscheidung aus der Gasphase im Bereich eines hohen Plasmawiderstands vorgenommen wird. Eine bevorzugte Maßnahme zum Einstellen des hohen Plasmawiderstands besteht darin, daß der absolute Massenfluß des Metallhalogenids auf mindestens 60 sccm eingestellt wird.

Fig. 1

Xerox Copy Centre

## Verfahren zur glimmentladungsaktivierten reaktiven Abscheidung von Metall aus einer Gasphase

Die Erfindung betrifft ein Verfahren zur reaktiven Abscheidung von rohrförmigen Körpern aus Metall aus einer ein Metallhalogenid enthaltenden strömenden Gasphase auf einem rohrförmigen Substrat, wobei zwischen einer Innenelektrode und einer Außenelektrode, von denen eine rohrförmig ausgebildet ist und als Substrat dient, eine Glimmentladung erzeugt wird.

Ein Verfahren dieser Art ist aus EP-A-O 204 356 bekannt. Bei dem darin beschriebenen Verfahren erfolgt eine gesteuerte Hin- und Herbewegung der Innenelektrode relativ zur Außenelektrode. Zwischen der Innenelektrode und der Außenelektrode wird eine lokal begrenzte Glimmentladungszone erzeugt, die während der Abscheidung beibehalten wird. Dabei werden Maßnahmen getroffen, um die Bildung von elektrisch leitenden Schichten auf elektrisch isolierenden Konstruktionsteilen im Reaktionsraum zu verhindern. Die Temperatur im Substratbereich wird auf einem niedrigen Wert konstant gehalten, bei dem die thermische Abscheiderate klein ist gegenüber der Abscheiderate mit Glimmentladung.

Bei dem bekannten Verfahren werden Massenflüsse an Wolframfluorid von bis zu 50 sccm, d.h. bis zu 50 cm$^3$ min, bezogen auf Standardbedingungen (0$^\circ$ C, 10$^5$ Pa), angewendet. Das bekannte Verfahren hat den Nachteil, daß mit ihm in manchen Fällen eine unerwartet niedrige Ausbeute der Metallabscheidung erhalten wird.

Der Erfindung liegt die Aufgabe zugrunde, eine hohe Metallabscheidung sicherzustellen.

Diese Aufgabe wird erfindungsgemäß dadurch gelöst, daß bei einem Verfahren der eingangs genannten Art die reaktive Abscheidung aus der Gasphase im Bereich eines hohen Plasmawiderstands vorgenommen wird.

Eine bevorzugte Maßnahme zum Einstellen des hohen Plasmawiderstands besteht darin, daß der absolute Massenfluß des Metallhalogenids auf mindestens 60 sccm eingestellt wird. Nach oben hin ist der absolute Massenfluß des Metallhalogenids lediglich durch den Strömungsquerschnitt im jeweils benutzten Massenflußregler begrenzt.

Zusätzliche vorteilhafte Maßnahme zur Erzielung einer hohen, in manchen Fällen sogar 100%igen Metallabscheidung bestehen darin,
- daß die Glimmentladung mit einem Entladungsstrom von mindestens 0,4 A erzeugt wird und/oder
- daß die strömende Gasphase mindestens ein Fluorid von Wolfram, Molybdän oder Rhenium sowie zusätzlich ein Inertgas und Wasserstoff enthält, wobei
- die strömende Gasphase bei der Abscheidung von Mehrkomponentenmaterial als weitere Komponente mindestens eine metallorganische Verbindung eines Elements der Gruppe III b des Periodensystems (Scandiumgruppe und Actiniden) enthält, und/oder
- daß die strömende Gasphase Wolframfluorid und Wasserstoff im Molverhältnis H$_2$ : WF$_6$ = 6 bis 8 : 1 enthält und/oder
- daß die Glimmentladung zwischen einer rohrförmig ausgebildeten, als Substrat dienenden Außenelektrode und einer Innenelektrode erzeugt wird, wobei die Länge des Teils der Innenelektrode, der in die Glimmentladung hineinragt, gleich dem Innendurchmesser der Außenelektrode oder größer als deren Innendurchmesser ist.

Das erfindungsgemäße Verfahren hat den Vorteil, daß durch die erzielte hohe Ausbeute zugleich auch das Entsorgungsproblem entschärft wird.

Verfahren zur reaktiven Abscheidung von Schichten und Formkörpern aus einer Gasphase werden als CVD-Verfahren bezeichnet. Verfahren, bei denen die Abscheidungsreaktion durch ein Plasma aktiviert wird, werden als PCVD-Verfahren bezeichnet.

Die Lehre, bei einem PCVD-Verfahren, bei dem elektrisch leitende Schichten abgeschieden werden, einen hohen Plasmawiderstand anzuwenden, beruht auf Untersuchungen der Gleichstrom-Glimmentladung in einem Gasgemisch aus Wolframhexafluorid (WF$_6$), Wasserstoff (H$_2$) und Argon (Ar), bei denen neuartige und bisher nicht erwartete Eigenschaften des Plasmas gefunden wurden, deren Kenntnis für eine optimale Verfahrensführung bzw. -ausbeute notwendig ist. Es wurde festgestellt, daß in Abhängigkeit vom absoluten WF$_5$-Massenfluß zwei verschiedene Plasmazustände des WF$_6$ + H$_2$ + Ar-Plasmas existieren, die sich vor allem durch den Plasmawiderstand unterscheiden. Je nach Geometrie und Verfahrens-Parametern wie Druck. Temperatur und Glimmentladungsstrom erhält man in einem in der Zeichnung dargestellten Diagramm des Spannungsabfalls U$_{p1}$ zwischen Kathode und Anode gegen den absoluten WF$_5$-Massenfluß Q$_{abs}$(WF$_5$) bei sonst konstanten Bedingungen entweder einen ziemlich abrupten oder einen kontinuierlichen Übergang zwischen beiden Zuständen. Dabei wird der Zustand mit hohem Plasmawiderstand bei einem absoluten WF$_5$-Massenfluß oder -Durchsatz von etwa 60 sccm erreicht. Dieser Übergang wird jedoch nicht

durch den relativen $WF_5$-Anteil im Gas bestimmt, wie durch eine starke Variation des Ar-Gasflusses nachgewiesen werden konnte, sondern nur vom absoluten $WF_5$-Massenfluß. Die Änderung von $\dot{Q}(Ar)$ führt nur zu geringfügigen Verschiebungen von $U_{p1}(Q(WF_5))$. Nach einem von F. Weling aufgestellten theoretischen Modell für Mikrowellenplasma-aktivierte CVD in einem rohrförmigen durchströmten Reaktor (J. Appl. Phys. 57 (1985) 4441-4446) sollte bei genügend hoher im Plasma absorbierter Leistung eine Verringerung der Strömungsgeschwindigkeit und damit des Massenflusses auch eine 100%ige Abscheidung im Rohr liefern. Für den Fall der Glimmentladung im $WF_5$-haltigen Gas gilt das jedoch nicht. Das Experiment zeigt, daß nur im Zustand mit hohem Plasmawiderstand (hohe Entladungsspannung) eine hohe Abscheidung erzielt werden kann. Eine Verringerung des $WF_5$-Massenflusses bewirkt überraschenderweise auch eine starke Verringerung der Ausbeute. Für eine hohe Verfahrensausbeute ist es also bei der Glimmentladung in $WF_5 + H_2 + Ar$ notwendig, die Verfahrensparameter im Bereich des Zustands mit hohem Plasmawiderstand zu wählen. Dies beruht im wesentlichen auf dem nichtlinearen Zusammenhang zwischen $U_{p1}$ und $\dot{Q}(WF_5)$.

Das Vorhandensein von zwei Plasmazuständen hängt offensichtlich damit zusammen, daß $WF_5$ ein stark elektronegatives Gas ist und eine relativ hohe Durchschlagsfestigkeit hat. Vor allem bei niedrigen Elektronenenergien können durch Elektronen-Einfang negative Ionen gebildet werden, die zur Anode wandern und eine viel geringere Beweglichkeit als die viel schnelleren Elektronen besitzen, so daß der Plasmawiderstand wächst. Das führt in der Regel zur Ausbildung einer negativen Ionen-Raumladungswolke vor der Anode und zusätzlich zu einer verstärkten positiven Ionenwolke vor der Kathode und damit zu einer Erhöhung des Plasmawiderstands mit zunehmender $WF_5$-Dichte.

Aus der Literatur (H. Boenig, Plasma Science and Technology, Cornell Univ. Press, S. 49) ist die Existenz zweier verschiedener Plasmazustände der positiven Säule in einem reinen $O_2$-Plasma bekannt. Sie werden von ihrem Entdecker Güntherschulze (1927) als H- und T-Form bezeichnet (H = hoch, T = tief) und unterscheiden sich durch hohe Spannungsgradienten und graugrüne Lumineszenz oder tiefere, d.h. niedrigere Spannungsgradienten der Gleichstrom-Entladung und violette Farbe. Die H-Form existiert bei höheren Strömen und niedrigeren Drücken als die T-Form. Bei gleichzeitiger Existenz sind die beiden Formen räumlich getrennt, wobei sich die H-Form auf der Anodenseite und die T-Form auf der Kathodenseite befinden.

Demgegenüber zeigen die nunmehr gefundenen zwei Plasmazustände im $WF_5 + H_2 + Ar$-Gasgemisch im Unterschied zu denen im reinen $O_2$-Plasma ein anderes Verhalten. Der Zustand mit hohem Spannungsabfall tritt gerade bei hohem $WF_5$-Massenfluß, d.h. hohem $WF_5$-Partialdruck auf, was konsistent ist mit der niedrigen Entladespannung im $Ar + H_2$-Plasma, dessen Einfluß bei niedrigem $WF_5$-Gehalt dominiert. Trotz dieser wesentlichen Unterschiede werden hier die Bezeichnungen H- und T-Form übernommen.

Die bei einer Mehrkomponenten-Abscheidung, z.B. zusammen mit $Th(tfa)_4$, erzeugte Schichtzusammensetzung wird durch die vom $WF_5$-Massenfluß abhängige W-Ausbeute beeinflußt, so daß der W-Anteil mit steigendem $WF_5$-Fluß überproportional wächst. Zur Realisierung einer vorgegebenen Festkörperzusammensetzung muß dieser Effekt berücksichtigt werden. Ein weiterer Effekt spielt jedoch gerade in diesem Fall eine zusätzliche Rolle. Erhöht man den $Th(tfa)_4$-Massenfluß bei konstantem $WF_5$-Massenfluß und zunächst 100%iger W-Ausbeute, so sinkt diese deutlich ab und man erhält wiederum eine überproportionale Abnahme des W-Anteils, wohl bedingt durch die zusätzliche Blockierung von Oberflächenzentren. Zur Realisierung vorgegebener Konzentrationen gilt also ebenfalls obige Feststellung. Nicht das Verhältnis $\dot{Q}(WF_5):\dot{Q}(Th(tfa)_4)$ ist demnach entscheidend, sondern die absoluten Flüsse. Analoges Verhalten wird auch bei einer Ersetzung von $WF_5$ durch z.B. $ReF_5$ oder $MoF_5$ festgestellt, d.h. die Existenz zweier Plasmazustände muß auch z.B. bei $ReF_5 + H_2 + Ar$ oder bei $MoF_5 + H_2 + Ar$-Plasmen berücksichtigt werden, es muß also auch dort für eine Optimierung $U_{p1}(\dot{Q}(Me_nF_m))$ gemessen werden (Me = W,Mo,Re; F = Fluor).

Das erfindungsgemäße Verfahren ist bei der Herstellung von selbsttragenden Glühkathoden anwendbar Nach dem erfindungsgemäßen Verfahren hergestellte selbsttragende Materialien, Schichten und Formkörper sind aber auch für andere Hochtemperaturanwendungen geeignet. Solche sind z.B. Innenwandungen von Raketendüsen, Innenrohre von Hochleistungslasern, Schutzbehälter bzw. Überzüge in und um Kernreaktor-Komponenten und Innenwände von Plasmakammern.

Die Erfindung wird an Hand einer Zeichnung, die auch das bereits erwähnte Diagramm enthält, und einiger Ausführungsbeispiele näher erläutert. In der Zeichnung zeigen

Fig. 1 eine Vorrichtung zur Durchführung von glimmentladungsaktivierten reaktiven Abscheidungen schematisch im Schnitt,

Fig. 2 die Abhängigkeit des Spannungsabfalls zwischen Kathode und Anode vom absoluten $WF_5$-Massenfluß in einem Diagramm und

Fig. 3 den Spannungsabfall als Funktion des Gesamtdrucks in einem Diagramm.

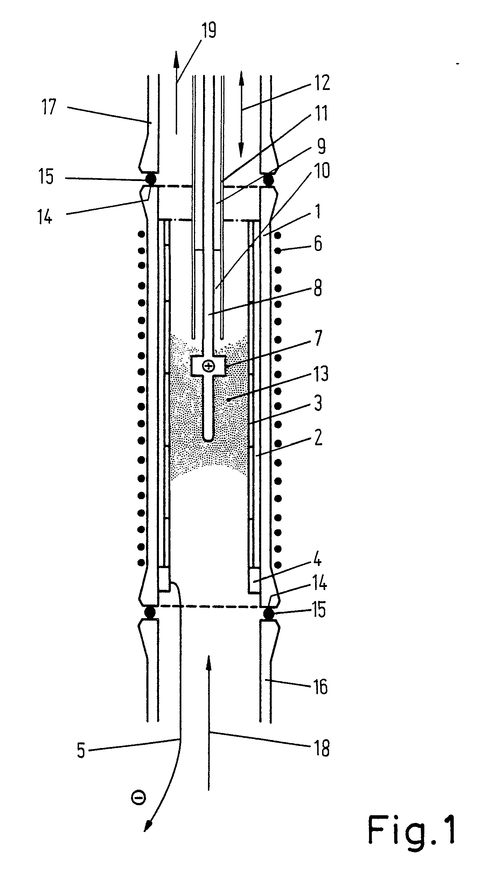

Fig. 1 zeigt schematisch einen Ausschnitt aus dem Bereich der Reaktionskammer. In einem Hüllrohr 1, das aus Quarz besteht, steckt ein zweites Hüllrohr 2 aus Edelstahl, das zusammensteckbar sein kann, und darin sind dünne Substratzylinder 3 auf einem Metallring 4 aus Kupfer oder Edelstahl koaxial aufgestapelt. Vom Metallring 4 führt ein elektrischer Anschluß 5 für die Kathode über eine (nicht dargestellte) Vakuum-Stromdurchführung zum Minus-Pol eines (nicht dargestellten) Gleichstrom-Netzgeräts. Um das Hüllrohr 1 sind zusätzlich Heizwicklungen 6 gewickelt, um die Substratzylinder bzw. Substratrohre auf einer definierten Temperatur zu halten, z.B. auf einer Temperatur von 370°C oder weniger, bzw. um für einen Ausgleich der zeitlich unterschiedlichen Wärmezufuhr durch das Plasma zu sorgen, wozu je nach Außenisolation und Dauer nach Einschalten des Plasmas eine Heizleistung von etwa 340 W erforderlich ist. Koaxial in der Rohrachse befindet sich eine Innenelektrode 7, die normalerweise als Anode geschaltet ist, und die längs dieser Achse über einen (nicht dargestellten) Linearantrieb und eine (nicht dargestellte) Vakuumdurchführung verschiebbar ist. Die als Scheibe mit vorgesetztem Stift ausgebildete Innenelektrode ist auf einen Montagestab 8 aus Edelstahl aufgeschraubt, der zugleich als Stromzuführung dient. Der Montagestab ist von einem Abschirmzylinder 9 aus $Al_2O_3$-Keramik umhüllt. Kurz vor der Elektrode bzw. Anode 7 beginnt ein etwa 1 bis 2 mm breiter und mehrere Zentimeter tiefer Rundumspalt 10, der einen durchgehenden elektrisch leitenden Bewuchs verhindert. Der Abschirmzylinder 9 ist zumindest in der Nähe der Anode 7 von einer Außenhülse 11 umgeben, die aus einem Material besteht, das ein Abblättern von elektrisch leitendem Bewuchs verhindert. Ein derartiges Material ist z.B. Elektrographit. Die Bewegbarkeit der Anode 7 samt Montagestab 8 und Abschirmzylinder 9 ist durch einen Doppelpfeil 12 angedeutet.

Zwischen der Anode 7 und den Substratzylindern 3 bildet sich eine Glimmentladung 13 aus. Das Hüllrohr 1 ist über Flansche 14 mit Dichtringen 15 aus einem ausheizbaren Kunststoff mit der übrigen Apparatur 16, 17 verbunden. Die durch einen Pfeil 18 angedeutete Gaszufuhr erfolgt auf der anodenabgewandten Seite, die durch einen Pfeil 19 angedeutete Gasentsorgung auf der Anodenseite.

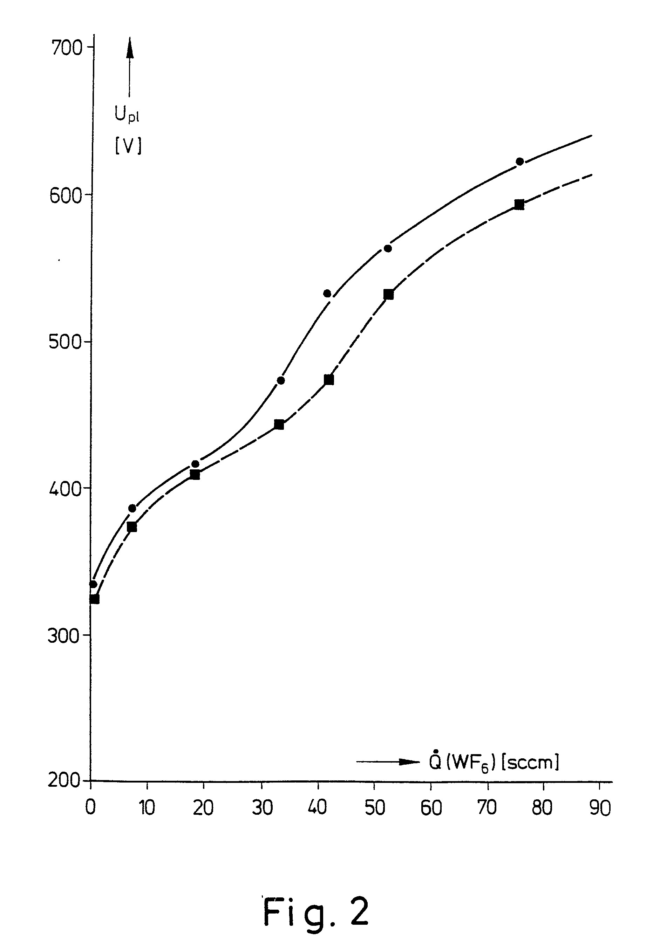

Fig. 2 zeigt die Entladungsspannung $U_{p1}$ als Funktion des $WF_6$-Massenflusses. Die Meßwerte, die den beiden Kurvenzügen in Fig. 2 zugrundeliegen, wurden mit Massenflüssen

$\dot{Q}(H_2)$ = 370 sccm

$\dot{Q}(Ar)$ = 375 sccm

bei einem von 0 bis 75 sccm ansteigendem Massenfluß $\dot{Q}_{abs}$ ($WF_6$) erhalten. Die Meßwerte, die dem durchgehend eingezeichneten Kurvenzug entsprechen, wurden bei einem

Entladungsstrom $I_{p1}$ = 0,45 A,

einem Gesamtdruck p = 8,3 hPa

und einer mittleren Außenwandtemperatur $T_m$ = 370°C

erhalten, die Meßwerte entsprechend dem gestrichelten Kurvenzug bei

$I_{p1}$ = 0,45 A

p = 12 hPa

$T_m$ = 370°C.

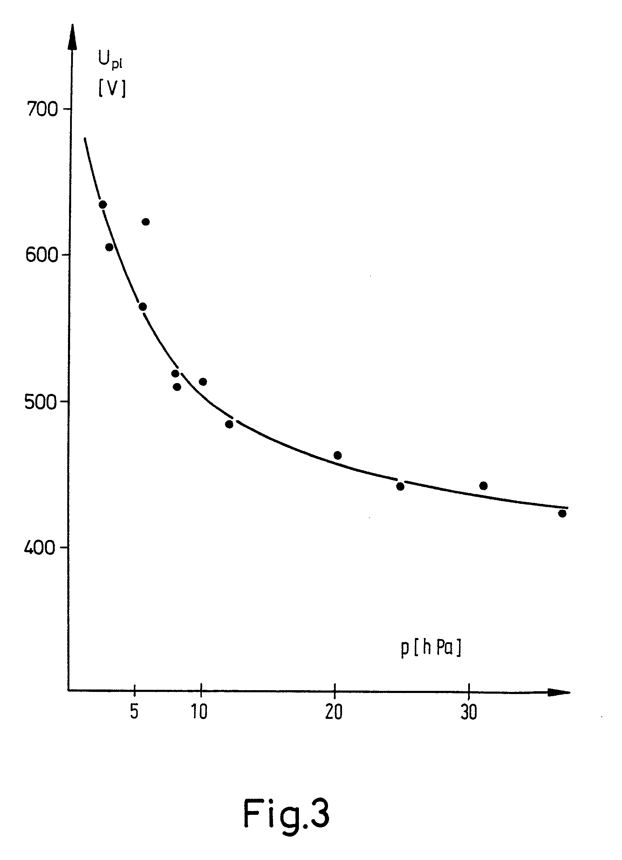

Fig. 3 zeigt die Entladungsspannung $U_{p1}$ als Funktion des Gesamtdrucks p im Reaktionsraum für

$\dot{Q}(WF_6)$ = 62 sccm

$\dot{Q}(H_2)$ = 370 sccm

$\dot{Q}(Ar)$ = 326 sccm

und eine mittlere Außenwandtemperatur von 420°C.

Auffällig ist, daß bis zu einem Gesamtdruck von etwa 40 hPa kein erneuter Anstieg der Entladungsspannung erkennbar ist, wie er nach dem Paschen-Gesetz für ansteigenden Druck jenseits des Minimums der Entladungsspannung zu erwarten wäre. Im Unterschied zum durchströmten Reaktor gilt jedoch das Paschen-Gesetz zunächst für eine stationäre Gasphase, so daß der Effekt der Strömung hier noch berücksichtigt werden muß.

Um eine Erhöhung der Plasmaleistung $L_{p1}$ zu erreichen, kann also auch der Gesamtdruck erniedrigt werden. und zwar vor allem wirksam im Bereich des hohen Plasmawiderstands.

Bei Versuchen, die mit der in Fig. 1 dargestellten Vorrichtung durchgeführt wurden, wurden folgende optimale Bedingungen für eine 100%ige Abscheidung gefunden:

4

- ausreichende Länge

der Anode: $l_A \gtrsim 35$ mm

- $I_{pl} \gtrsim 0,4$ A

- $\dot{Q}(WF_6) = 18$ bis $90$ sccm

- $H_2{:}WF_6 = 6{:}1$ bis $8{:}1$, vorzugsweise $6,6{:}1$

- Gesamtdruck p $\lesssim$ $12$ hPa

- $U_{pl} \gtrsim$ $420$ V

- $L_{pl} \gtrsim$ $200$ W.

**Ansprüche**

1. Verfahren zur reaktiven Abscheidung von rohrförmigen Körpern aus Metall aus einer ein Metallhalogenid enthaltenden strömenden Gasphase auf einem rohrförmigen Substrat, wobei zwischen einer Innenelektrode und einer Außenelektrode, von denen eine rohrförmig ausgebildet ist und als Substrat dient, eine Glimmentladung erzeugt wird,
dadurch gekennzeichnet, daß die reaktive Abscheidung aus der Gasphase im Bereich eines hohen Plasmawiderstands vorgenommen wird.

2. Verfahren nach Anspruch 1,
dadurch gekennzeichnet, daß der absolute Massenfluß des Metallhalogenids auf mindestens 60 sccm eingestellt wird.

3. Verfahren nach Anspruch 1 oder 2,
dadurch gekennzeichnet, daß die Glimmentladung mit einem Entladungsstrom von mindestens 0,4 A erzeugt wird.

4. Verfahren nach Anspruch 1, 2 oder 3,
dadurch gekennzeichnet, daß die strömende Gasphase mindestens ein Fluorid von Wolfram, Molybdän oder Rhenium sowie zusätzlich ein Inertgas und Wasserstoff enthält.

5. Verfahren nach Anspruch 4,
dadurch gekennzeichnet, daß die strömende Gasphase bei der Abscheidung von Mehrkomponentenmaterial als weitere Komponente mindestens eine metallorganische Verbindung eines Elements der Gruppe III b des Periodensystems enthält.

6. Verfahren nach Anspruch 4 oder 5,
dadurch gekennzeichnet, daß die strömende Gasphase Wolframfluorid und Wasserstoff im Molverhältnis $H_2 : WF_6 = 6$ bis $8 : 1$ enthält.

7. Verfahren nach einem oder mehreren der Ansprüche 1 bis 6,
dadurch gekennzeichnet, daß die Glimmentladung zwischen einer rohrförmig ausgebildeten, als Substrat dienenden Außenelektrode und einer Innenelektrode erzeugt wird, wobei die Länge des Teils der Innenelektrode, der in die Glimmentladung hineinragt, gleich dem Innendurchmesser der Außenelektrode oder größer als deren Innendurchmesser ist.

Fig.1

Fig. 2

2-III-PHD 87-242

Fig.3